# EUROPEAN PATENT APPLICATION

(11) **EP 3 327 866 A1**
(43) Date of publication of application: **30.05.2018**
(21) Application number: 16827808.3
(22) Date of filing: 20.07.2016
(51) Int. Cl.: H01R 4/02, B60S 1/02, C03C 17/06, H01R 12/51, H05K 3/34

(54) **GLASS PLATE MODULE**

(30) Priority: 22.07.2015 JP 2015145350
(71) Applicant: Nippon Sheet Glass Company, Limited, Tokyo 108-6321 (JP)
(72) Inventor: TOKIWA, Junichi, Tokyo 108-6321 (JP)
(74) Representative: Webster, Jeremy Mark
(86) International application number: PCT/JP2016/071328
(87) International publication number: WO 2017/014248

(57) **Abstract**

A glass plate module includes a glass plate (1), an electrically conductive layer (21) laminated on the glass plate (1), a plurality of electrically conductive cables (52) extending from a plurality of connectors or extending from a single connector, a plurality of connection terminals (3) arranged on the electrically conductive layer at an interval, connected to the respective electrically conductive cables, and made of an electrically conductive material, lead-free solder (4) for fixing the connection terminals (3) to the electrically conductive layer (21), and a binding member (53) that binds the plurality of electrically conductive cables (52) together between the connector(s) and the connection terminals.

## Description

### Technical Field

The present invention relates to a glass plate module that is mounted to a window frame of a structure, a convertible car provided with the glass plate module, and a method for producing a glass plate module.

### Background Art

For example, Patent Literature 1 discloses a connection terminal that is connected to an electrically conductive layer of a glass plate of an automobile. An electrically conductive cable extending from a wire harness, for example, is connected to such a connection terminal, and electric power is supplied to the electrically conductive layer via the connection terminal.

### Citation List

### Patent Literature

Patent Literature 1: JP H7-329724A

### Summary of Invention

### Technical Problem

Incidentally, in recent years, there has been a tendency to use lead-free solder to fix a connection terminal to an electrically conductive layer. However, since lead-free solder is hard when compared with conventional lead-containing solder, there is a risk that if the electrically conductive cable connected to the connection terminal is suddenly pulled, the lead-free solder, the electrically conductive layer, or the glass plate will crack, and the connection terminal will become detached from the electrically conductive layer.

The present invention was made in order to address the foregoing problem, and it is an object thereof to provide a glass plate module with which, in the case where connection terminals to which a plurality of electrically conductive cables are connected are fixed to the electrically conductive layer, the electrically conductive layer and the glass plate can be prevented from cracking even if an external force is exerted on an electrically conductive cable, and a method for producing the glass plate module.

### Solution to Problem

A glass plate module according to the present invention includes a glass plate, an electrically conductive layer laminated on the glass plate, a plurality of electrically conductive cables extending from a plurality of connectors or extending from a single connector, a plurality of connection terminals arranged on the electrically conductive layer at an interval, connected to the respective electrically conductive cables, and made of an electrically conductive material, and a binding member that binds the plurality of electrically conductive cables together between the connector(s) and the connection terminals.

With this configuration, since the plurality of electrically conductive cables are bound together between the connector(s) and the connection terminals, tensile force and rotation moment that are transmitted to the connection terminals from the connector (s) via the electrically conductive cables can be alleviated. As a result, the electrically conductive layer and the glass plate can be prevented from cracking, and the connection terminals can be prevented from becoming detached from the electrically conductive layer. In particular, in the present invention, the connection terminals are fixed to the electrically conductive layer using lead-free solder, which has low ductility, and thus, a force exerted on a connection terminal is likely to cause stress or the like to concentrate at an end edge of a contact portion between the lead-free solder and the electrically conductive layer, which leads to cracking. Accordingly, it is especially advantageous to employ a binding member such as that described above in the glass plate module of the present invention in which lead-free solder is used.

In the above-described glass plate module, various types of connection terminals can be used as the connection terminals . For example, connection terminals each having an installation portion that is to be installed on the electrically conductive layer and a connection portion to which an electrically conductive cable is to be connected can be used as the connection terminals. In addition, it is possible to arrange two connection terminals adjacent to each other on the electrically conductive layer such that the connection portions of the two connection terminals oppose each other, and the electrically conductive cables are bound together by the binding member between the two connection portions.

In each of the above-described glass plate modules, it is possible that the lead-free solder has an Sn content of 90% or more.

In each of the above-described glass plate modules, it is preferable that at least a portion of the lead-free solder has a shape that is flared from the connection terminal side toward the electrically conductive layer.

A convertible car according to the present invention includes any one of the above-described glass plate modules.

A first method for producing a glass plate module according to the present invention includes preparing a glass plate on which an electrically conductive layer is laminated; preparing a plurality of electrically conductive cables extending from a plurality of connectors or extending from a single connector; attaching connection terminals to the respective electrically conductive cables, applying lead-free solder to the connection terminals; applying a flux to the lead-free solder; and melting the lead-free solder by applying energy from outside to the connection terminals, to thereby fix the connection terminals onto the electrically conductive layer via the lead-free solder, wherein the plurality of electrically conductive cables are bound together between the connector(s) and the connection terminals.

With this configuration, not only the above-described effects associated with the glass plate module can be achieved, but also the following effect can be achieved. That is to say, since the flux is applied to the lead-free solder applied to the connection terminals, once the connection terminals have been fixed to the electrically conductive layer, the lead-free solder and the flux are present between the electrically conductive layer and the connection terminals, and are thus unlikely to be seen from the outside. Therefore, the flux, which may discolor, is unlikely to be seen from the outside, and degradation of the design of the glass plate module can be prevented.

A second method for producing a glass plate module according to the present invention includes preparing a glass plate on which an electrically conductive layer is laminated; preparing a plurality of electrically conductive cables extending from a plurality of connectors or extending from a single connector; attaching connection terminals to the respective electrically conductive cables; applying lead-free solder to the connection terminals; applying a flux to a portion of the electrically conductive layer; and melting the lead-free solder by applying energy from outside to the connection terminals, to thereby fix the connection terminals, via the lead-free solder, onto the electrically conductive layer to which the flux has been applied, wherein the plurality of electrically conductive cables are bound together between the connector(s) and the connection terminals.

With this configuration, not only the above-described effects associated with the glass plate module can be achieved, but also the following effect can be achieved. That is to say, with this configuration, the flux is applied to a portion of the electrically conductive layer, and each connection terminal is fixed, via the lead-free solder, to a portion where the flux has been applied. Here, since lead-free solder tends to spread out when melted, if the flux is applied to the electrically conductive layer in advance with consideration given to this tendency, the lead-free solder and the flux can be reliably brought into contact with each other. As a result, the connection terminals can be effectively fixed to the electrically conductive layer via the lead-free solder.

A third method for producing a glass plate module according to the present invention includes preparing a glass plate on which an electrically conductive layer is laminated; preparing a plurality of electrically conductive cables extending from a plurality of connectors or extending from a single connector; preparing connection terminals to which lead-free solder is applied; attaching the connection terminals to the respective electrically conductive cables; applying a flux to the lead-free solder; and melting the lead-free solder by applying energy from outside to the connection terminals, to thereby fix the connection terminals onto the electrically conductive layer via the lead-free solder, wherein the plurality of electrically conductive cables are bound together between the connector(s) and the connection terminals.

A fourth method for producing a glass plate module according to the present invention includes preparing a glass plate on which an electrically conductive layer is laminated; preparing a plurality of electrically conductive cables extending from a plurality of connectors or extending from a single connector; preparing connection terminals to which lead-free solder is applied; attaching the connection terminals to the respective electrically conductive cables; applying a flux to a portion of the electrically conductive layer; and melting the lead-free solder by applying energy from outside to the connection terminals, to thereby fix the connection terminals, via the lead-free solder, onto the electrically conductive layer to which the flux has been applied, wherein the plurality of electrically conductive cables are bound together between the connector (s) and the connection terminals.

A fifth method for producing a glass plate module according to the present invention includes preparing a glass plate on which an electrically conductive layer is laminated; preparing connection terminals to which a plurality of electrically conductive cables extending from a plurality of connectors or extending from a single connector are attached and lead-free solder is applied; applying a flux to the lead-free solder; and melting the lead-free solder by applying energy from outside to the connection terminals, to thereby fix the connection terminals onto the electrically conductive layer via the lead-free solder, wherein the plurality of electrically conductive cables are bound together between the connector (s) and the connection terminals.

A sixth method for producing a glass plate module according to the present invention includes preparing a glass plate on which an electrically conductive layer is laminated; preparing connection terminals to which a plurality of electrically conductive cables extending from a plurality of connectors or extending from a single connector are attached and a flux and lead-free solder are applied; attaching the connection terminals to the respective electrically conductive cables; and melting the lead-free solder by applying energy from outside to the connection terminals, to thereby fix the connection terminals onto the electrically conductive layer via the lead-free solder, wherein the plurality of electrically conductive cables are bound together between the connector(s) and the connection terminals.

A seventh method for producing a glass plate module according to the present invention includes preparing a glass plate on which an electrically conductive layer is laminated; preparing connection terminals to which a plurality of electrically conductive cables extending from a plurality of connectors or extending from a single connector are attached and a flux and lead-free solder are applied, the plurality of electrically conductive cables being bound together; attaching the connection terminals to the respective electrically conductive cables; and melting the lead-free solder by applying energy from outside to the connection terminals, to thereby fix the connection terminals onto the electrically conductive layer via the lead-free solder.

An eighth method for producing a glass plate module according to the present invention includes preparing a glass plate on which an electrically conductive layer is laminated; preparing connection terminals to which a plurality of electrically conductive cables extending from a plurality of connectors or extending from a single connector are attached and lead-free solder is applied; applying a flux to a portion of the electrically conductive layer; and melting the lead-free solder by applying energy from outside to the connection terminals, to thereby fix the connection terminals onto the electrically conductive layer via the lead-free solder, wherein the plurality of electrically conductive cables are bound together between the connector (s) and the connection terminals.

Note that, according to the first to eighth methods for producing a glass plate module, the plurality of electrically conductive cables are bound together. The cables may be bound together prior to the connection terminals being connected to the electrically conductive cables or after the connection terminals have been fixed to the electrically conductive layer, and the timing of binding is not limited. Moreover, in each of the above-described production methods, "applying energy from outside to the connection terminals" means the application of energy for melting the lead-free solder. This means that the lead-free solder is melted by applying energy related to, for example, heating, hot air, high-frequency waves, or the like. In addition, in each of the above-described aspects of the invention, "cable" encompasses a thin wire such as a conductor.

### Advantageous Effects of Invention

According to the present invention, in the case where connection terminals to which a plurality of electrically conductive cables are connected are fixed to the electrically conductive layer, the electrically conductive layer and the glass plate can be prevented from cracking even if an external force is exerted on the electrically conductive cables.

### Brief Description of Drawings

FIG. 1 is a plan view of a glass plate module according to an embodiment of the present invention.
FIG. 2 is a front view of a wire harness used for the glass plate module in FIG. 1.
FIG. 3 is a side view of a connection terminal for use in the glass plate module in FIG. 1.
FIG. 4 is a plan view of the connection terminal in FIG. 2.
FIG. 5 shows side views illustrating a method for attaching the connection terminal shown in FIG. 1.
FIG. 6 is a side view illustrating the method for attaching the connection terminal shown in FIG. 1.
FIG. 7 is a side view illustrating the method for attaching the connection terminal shown in FIG. 1.
FIG. 8 is a side view illustrating the method for attaching the connection terminal shown in FIG. 1.
FIG. 9 is a side view illustrating the method for attaching the connection terminal shown in FIG. 1.

### Description of Embodiments

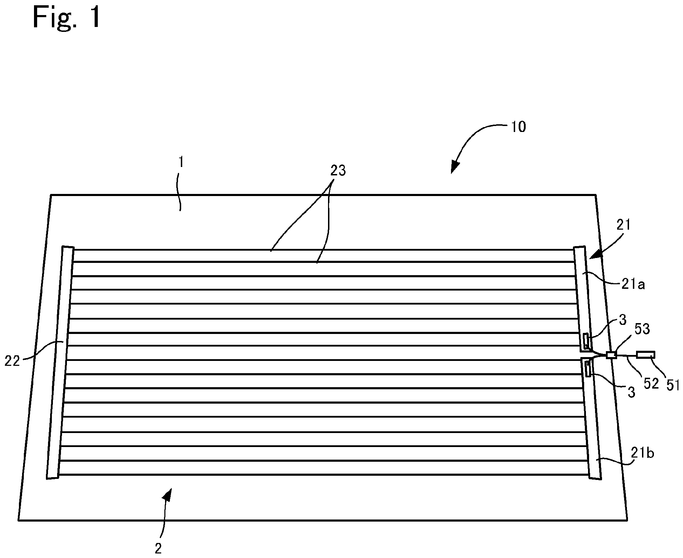

An embodiment of a glass plate module according to the present invention will be described below with reference to the drawings. FIG. 1 is a plan view of this glass plate module. As shown in FIG. 1, the glass plate module according to this embodiment is to be fitted in a window frame of an automobile. Specifically, this glass plate module 10 has a glass plate 1, a defogger 2 (an electrically conductive layer) laminated on this glass plate 1, and two connection terminals 3 that are attached to this defogger 2 using lead-free solder 4. Electrically conductive cables 52 extending from a wire harness 5 are respectively attached to the two connection terminals 3 that are adjacent to each other at one end portion of the defogger 2, and an electric current supplied from the electrically conductive cables 52 is supplied to the defogger via the connection terminals 3. The constituent members will be described below.

### 1. Glass plate

A known automotive glass plate can be used as the glass plate 1. For example, heat absorbing glass, regular clear glass or green glass, or UV green glass may be used as the glass plate 1. However, the glass plate 1 as described above is required to attain visible light transmittance that conforms to the safety standards of the country in which the automobile is to be used. For example, an adjustment can be made such that solar absorptance, visible light transmittance, and the like satisfy the safety standards. An example of the composition of clear glass and an example of the composition of heat absorbing glass are shown below.

### Clear Glass

SiO₂: 70 to 73 mass%
Al₂O₃: 0.6 to 2.4 mass%
CaO: 7 to 12 mass%
MgO: 1.0 to 4.5 mass%
R²O: 13 to 15 mass% (R is an alkali metal)
Total iron oxide (T-Fe₂O₃) in terms of Fe₂O₃: 0.08 to 0.14 mass%

### Heat Absorbing Glass

With regard to the composition of heat absorbing glass, a composition obtained based on the composition of clear glass by setting the ratio of the total iron oxide (T-Fe₂O₃) in terms of Fe₂O₃ to 0.4 to 1.3 mass%, the ratio of CeO₂ to 0 to 2 mass%, and the ratio of TiO₂ to 0 to 0.5 mass% and reducing the components (mainly SiO₂ and Al₂O₃) forming the framework of glass by an amount corresponding to the increases in T-Fe₂O₃, CeO₂, and TiO₂ can be used, for example.

Note that the type of the glass plate 1 is not limited to clear glass or heat absorbing glass, and can be selected as appropriate according to the embodiment. For example, the glass plate 1 may be a resin window made of acrylic resin, polycarbonate resin, or the like.

In addition, the thickness of the glass plate 1 according to this embodiment does not have to be limited particularly. However, from the viewpoint of weight reduction, the thickness of the glass plate 1 may be set in a range of 2.2 to 5.1 mm, a range of 2.4 to 3.8 mm, and a range of 2.7 to 3.2 mm. Furthermore, the thickness of the glass plate 1 may be set to be 3.1 mm or smaller.

In addition, the glass plate 1 as described above may be laminated glass having an interlayer made of resin or the like sandwiched by a plurality of glass plates, instead of being a single glass plate.

### 2. Defogger

Next, the defogger 2 will be described. As shown in FIG. 1, the defogger 2 has a pair of a first busbar 21 and a second busbar 22 for supplying electric power, which extend in the up-down direction along two side edges of the glass plate 1. Of these busbars, the first busbar 21 on the right side is divided in the vicinity of its center in the up-down direction. In the following description, a section of the first busbar 21 that is disposed on the upper side will be referred to as an upper part 21a, and a section of the first busbar 21 that is disposed on the lower side will be referred to as a lower part 21b. The connection terminal 3 connected to a cathode is attached to the upper part 21a of the first busbar 21, and the connection terminal 3 connected to an anode is attached to the lower part 21b. In addition, a plurality of horizontal elements 23 are arranged in parallel at a predetermined interval between the busbars 21 and 22.

Due to this configuration, when an electric current is supplied to the defogger 2, defogging heat is generated in the horizontal elements 23. Note that the busbars 21 and 22 and the horizontal elements 23 are formed by printing electroconductive silver paste onto the surface of the glass plate 1 and firing the silver paste, for example. However, the material of the defogger 2 is not limited to this silver paste, and can be selected as appropriate.

### 3. Wire Harness

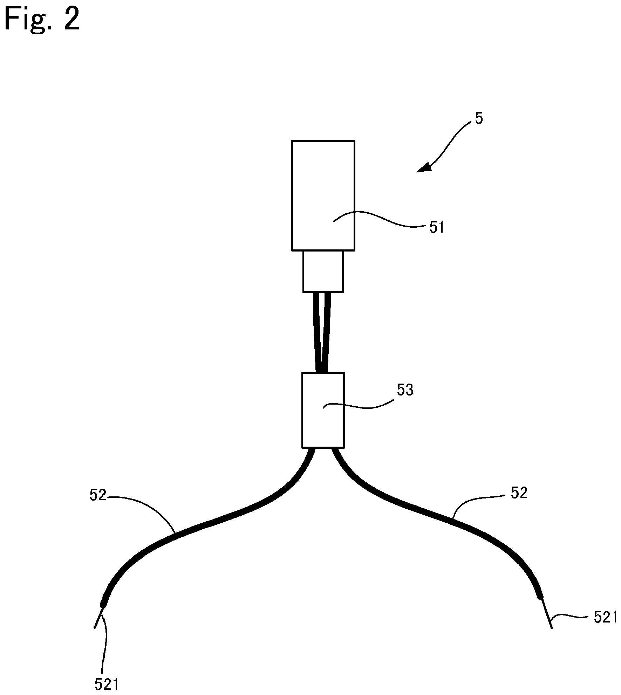

As shown in FIG. 2, a known wire harness is used as the wire harness 5, and the wire harness 5 includes a multiconductor connector 51 and the two electrically conductive cables that extend from the multiconductor connector 51. The multiconductor connector 51 is connected to a connector (not shown) extending from inside the automobile. The two electrically conductive cables 52 are respectively connected to the cathode and the anode via the multiconductor connector 51. In addition, the two electrically conductive cables 52 are connected to the respective connection terminals 3, and are coated with an electrically non-conductive coating material, such as rubber, except for both end portions thereof. More specifically, the end portions, that is, electrically conductive portions 521 that are connected to the respective connection terminals 3 are exposed from the coating material. Moreover, the two electrically conductive cables 52 are bound together by a binding member 53 in the vicinity of their middle portions. The binding member 53 is made of a resin material or the like and is formed in a tubular shape.

### 4. Connection Terminals

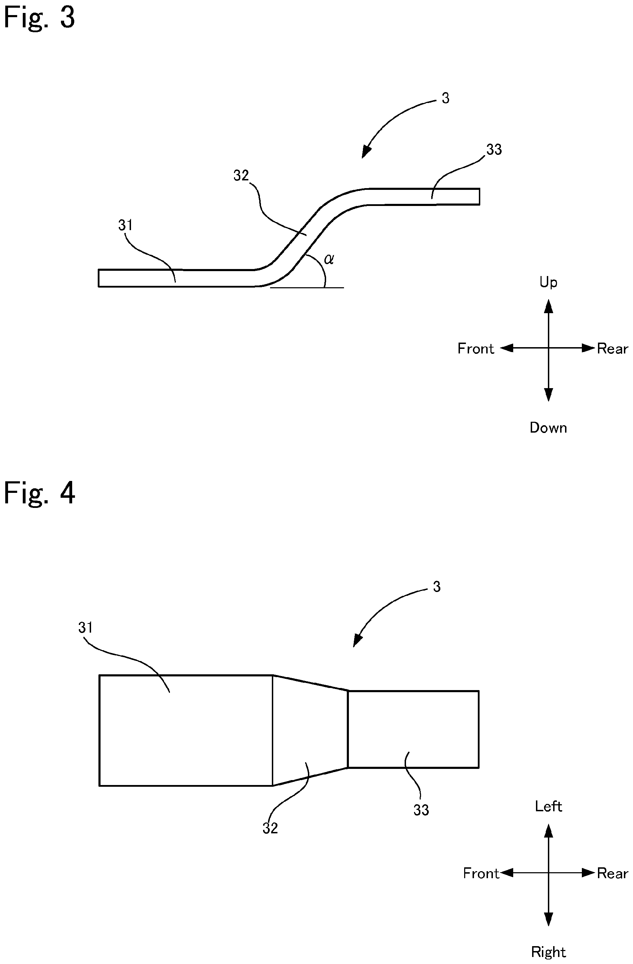

Next, the connection terminals 3 will be described. Description will be given with reference to FIGS. 3 and 4. FIG. 3 is a side view of a connection terminal, and FIG. 4 is a plan view of the connection terminal. For convenience of description, description will be given below based on the directions shown in FIG. 3. Specifically, description will be given with the up-down direction in FIG. 3 being referred to as the up-down direction, the right-left direction in FIG. 3 being referred to as the front-rear direction, and the up-down direction in FIG. 4 being referred to as the right-left direction or the width direction.

As shown in FIGS. 3 and 4, each connection terminal 3 according to this embodiment is formed integrally by folding an electrically conductive material such as a metal plate, and includes a plate-shaped installation portion 31 that is installed on the first busbar 21 of the defogger 2. The installation portion 31 is formed in a rectangular shape, and a lower surface thereof is fixed to the first busbar 21 via the lead-free solder 4.

A plate-shaped standing portion 32 that extends obliquely upward is integrally coupled to a rear end portion of the installation portion 31. The standing portion 32 is formed in a rectangular shape, and stands at an angle of about 30 degrees to the installation portion 31. Note that although the angle α that the standing portion 32 forms with the installation portion 31 is not limited to a specific angle, the angle α is preferably 10 to 90 degrees, for example.

In addition, a plate-shaped connection portion 33 that horizontally extends rearward is integrally coupled to an upper end portion of the standing portion 32. In plan view, the connection portion 33 is formed in a rectangular shape that is narrower than the installation portion 31. The end portion of a corresponding one of the above-described electrically conductive cables 52 is fixed to a rear end portion of the connection portion 33.

### 5. Solder

Next, the lead-free solder 4 that is applied to the installation portion 31 of the connection terminal 3 will be described. For example, the lead-free solder 4 whose Sn content is 90% or more is hard and may crack when joined to a laminated glass plate. Even in such a case, soft lead-free solder 4 such as indium solder and bismuth solder can be used for the joining.

### 6. Attachment of Connection Terminals

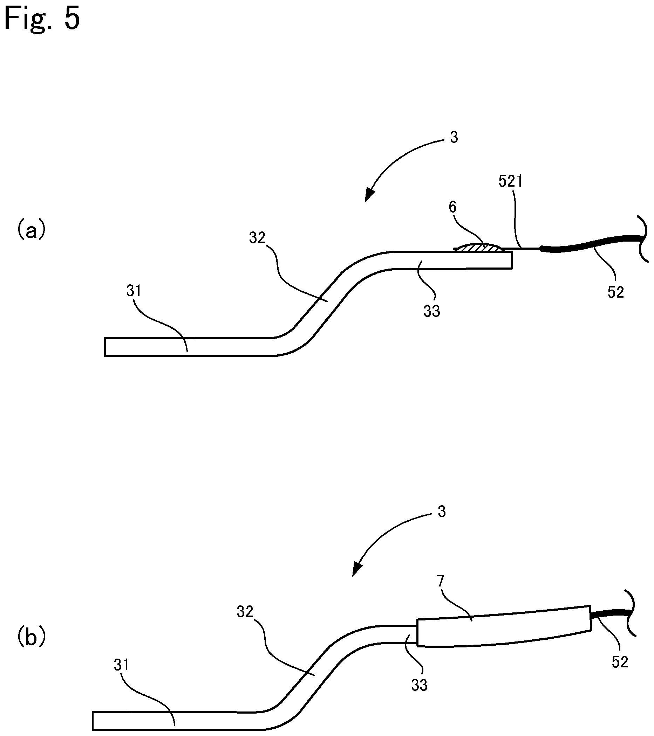

Next, a method for attaching each connection terminal 3 will be described with reference to FIGS. 5 to 9. As described above, the first busbar 21 is divided into the two sections, that is, the upper part 21a and the lower part 21b. The connection terminals 3 are respectively fixed to the upper part 21a and the lower part 21b on opposite sides of the divided portion. In addition, the above-described wire harness 5 is attached to the connection terminals 3. Detailed description will be given below.

First, the connection terminals 3 are respectively connected to the two electrically conductive cables 52 of the wire harness 5. Specifically, as shown in FIG. 5(a), the end portion, that is, the electrically conductive portion 521, which is exposed from the coating material, of each electrically conductive cable 52 is fixed to the connection portion 33 of a corresponding one of the connection terminals 3 using an adhesive member 6 such as solder or an electrically conductive adhesive. Subsequently, as shown in FIG. 5(b), the end portion of the electrically conductive cable 52 and the connection portion 33 of the connection terminal 3 are covered with an electrically non-conductive covering member 7 such that the electrically conductive portion 521 is covered.

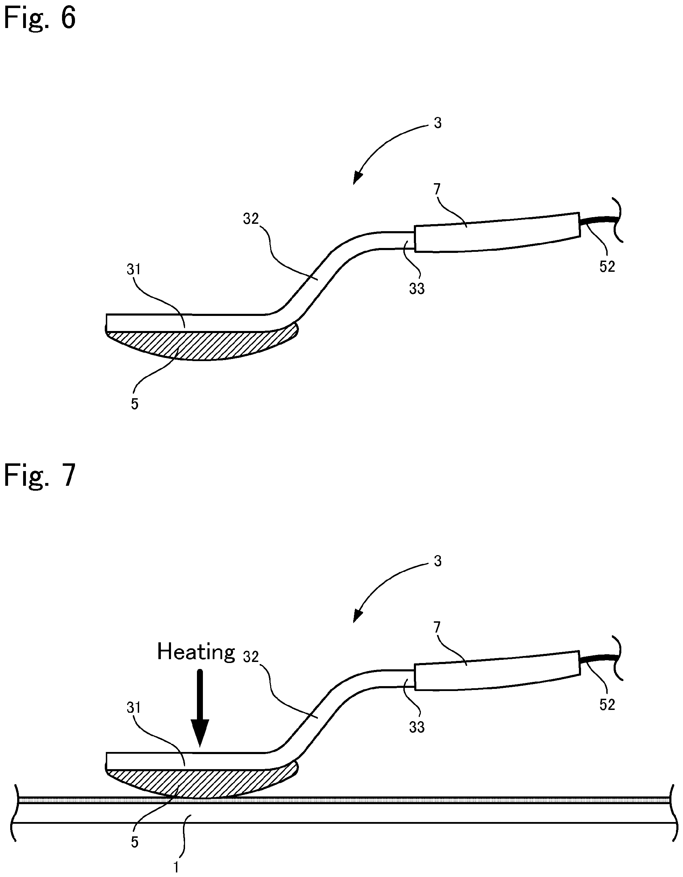

Next, as shown in FIG. 6, the lead-free solder 4 is applied to the lower surface of the installation portion 31. At this time, the amount of lead-free solder 4 that is applied is such that, as will be described later, the lead-free solder 4 is squeezed out past the installation portion 31 when attached to the first busbar 21.

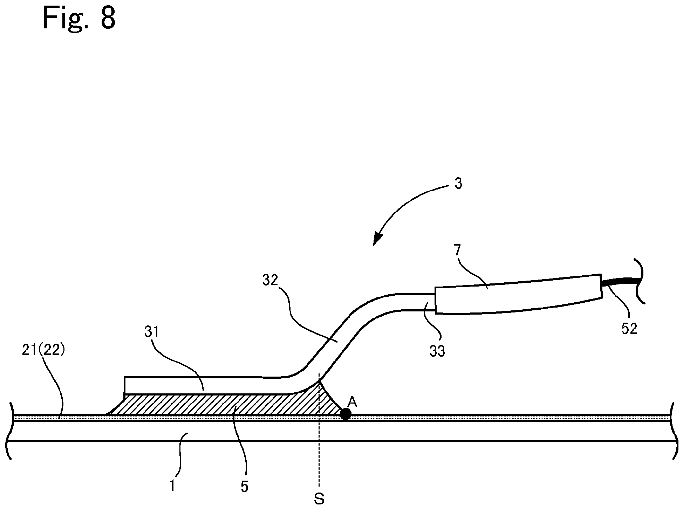

Subsequently, the connection terminal 3 that has been prepared as described above is fixed to the first busbar 21. First, as shown in FIG. 7, the lead-free solder 4 is placed on the first busbar 21. Subsequently, the upper surface side of the installation portion 31 of the connection terminal 3 is heated. Thus, the heat is transmitted to the lead-free solder 4 via the installation portion 31, and the lead-free solder 4 is melted. As a result, as shown in FIG. 8, the lead-free solder 4 spreads out in the surface direction of the glass plate 1 while being squeezed out past the installation portion 31. Then, as the lead-free solder 4 solidifies, the installation portion 31 is fixed to the first busbar 21. At this time, a portion of the lead-free solder 4 extends past a rear end S of the installation portion 31 toward the connection portion 33 and also has a shape that is flared toward the glass plate 1. That is to say, a rear end A of the lead-free solder 4 that is in contact with the first busbar 21 is located rearward of the rear end S of the installation portion 31.

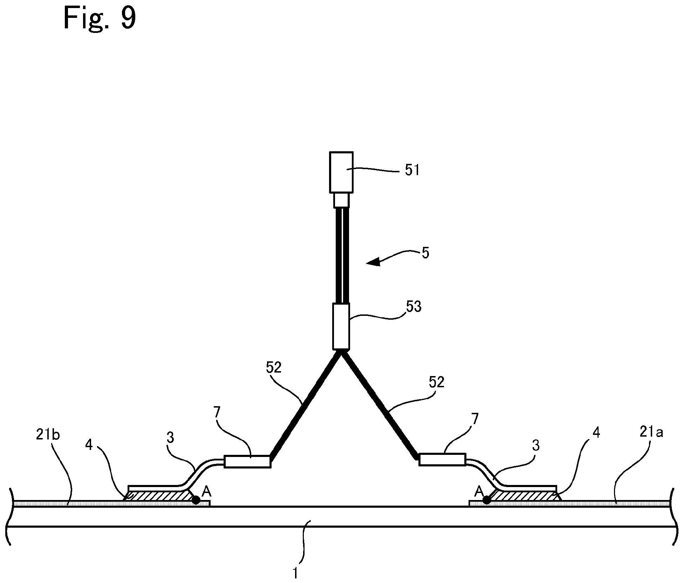

In this manner, the two connection terminals 3 are respectively fixed to the upper part 21a and the lower part 21b of the first busbar 21, and a state shown in FIG. 9 is thereby achieved. Thus, a glass plate module such as that shown in FIG. 1 is completed. After that, this glass plate module 10 is mounted to a window frame of an automobile, and then, the connector 51 of the wire harness 5 is connected to the connector inside the automobile.

### 7. Characteristics

As described above, according to the glass plate module of this embodiment, since the plurality of electrically conductive cables 52 are bound together between the connector 51 of the wire harness 5 and the connection terminals 3, tensile force and rotation moment that are transmitted from the connector 51 to the connection terminals 3 via the electrically conductive cables 52 can be alleviated. As a result, the first busbar 21 and the glass plate 1 can be prevented from cracking, and the connection terminals 3 can be prevented from becoming detached from the first busbar 21. In particular, in this embodiment, the connection terminals 3 are fixed to the first busbar 21 using the lead-free solder 4, which has low ductility, and thus, a force exerted on a connection terminal 3 is likely to cause stress or the like to concentrate at an end edge (e.g., the aforementioned point A) of a contact portion between the lead-free solder 4 and the first busbar 21, which leads to cracking. Therefore, it is especially advantageous to employ the above-described binding member 53 for the glass plate module of this embodiment in which the lead-free solder 4 is used.

Moreover, as shown in FIG. 9, since the lead-free solder 4 is flared toward the first busbar 21, the rear end A of the contact portion between the lead-free solder 4 and the first busbar 21 is located rearward of a coupling portion between the installation portion 31 and the standing portion 32. As a result, concentration of stress at the rear end A due to tensile force and rotation moment acting on the connection terminal 3 can be further prevented.

### 8. Variations

One embodiment of the present invention has been described above, but the present invention is not limited to the foregoing embodiment, and various modifications can be made without departing from the gist of the invention. In addition, a plurality of variations described as follows can be combined as appropriate.
1. In the foregoing embodiment, an example of the form of the connection terminal was described, but the form of the connection terminal is not limited to a specific form. Generally, a connection terminal in which the installation portion 31 to be fixed to the defogger 2 and the connection portion 33 to which the electrically conductive cable 52 is to be connected are separated from each other is used, but a connection terminal in which these portions are integrated may also be used. However, a configuration in which the standing portion 32 is provided has the following advantages. The lead-free solder 4 has the property of moving to a higher-temperature portion, and when the lead-free solder 4 is melted by heating the connection terminal 3, the temperature of the standing portion 32 and the connection portion 33 becomes higher than that of the glass plate 1. Thus, there is a possibility that the lead-free solder 4 will move toward the connection portion 33 against gravity. In this regard, since the connection terminal 3 of the above-described glass plate module 10 has the standing portion 32 between the installation portion 31 and the connection portion 33, the lead-free solder 4 can only move to the middle of the standing portion 32, and therefore can be prevented from reaching the connection portion 33. Thus, it is easy to form a lead-free solder 4 with a flared shape as described above. As a result, the rear end A of the contact portion between the lead-free solder 4 and the first busbar 21 can be located rearward of the coupling portion between the installation portion 31 and the standing portion 32. Note that not all end portions of the lead-free solder 4 are required to be flared, and a configuration may also be adopted in which at least one of the end portions of the lead-free solder 4 is flared.
   In addition, for example, although the connection portion 33 and the wire harness 5 of the foregoing embodiment are fixed to each other using solder or an adhesive, it is also possible to crimp the connection portion 33 onto the electrically conductive cable 52 or to attach a connector to a leading end of the electrically conductive cable 52 and fit the connector to the connection portion 33.
2. The lead-free solder 4 may be applied to the connection terminal 3 in advance as described in the foregoing embodiment, or it is also possible to apply the lead-free solder 4 to the connection terminal 3 prior to or after connecting the electrically conductive cable 52 to the connection terminal 3 or when fixing the connection terminal 3 to the first busbar 21. In addition, it is also possible to apply a flux to the lead-free solder 4 prior to fixing the lead-free solder 4 to the defogger 2 or to apply a flux onto the defogger 2 and fix the connection terminal 3 thereon via the lead-free solder 4.
   For example, in the case where a flux is applied, in advance, to the lead-free solder 4 applied to the connection terminal 3, once the connection terminal 3 has been fixed to the defogger 2, the lead-free solder 4 and the flux are present between the connection terminal 3 and the defogger 2 and are thus unlikely to be seen from the outside. Therefore, the flux, which may discolor, is unlikely to be seen from the outside, and degradation of the design of the glass plate module can be prevented.
   On the other hand, in the case where a flux is applied to a portion of the defogger 2, and the connection terminal 3 is fixed, via the lead-free solder 4, to the portion where the flux has been applied, the following effects are achieved. That is to say, the lead-free solder 4 tends to spread out when melted, and if a flux is applied to a large area on the defogger 2 in advance with consideration given to this tendency, the lead-free solder 4 and the flux can be reliably brought into contact with each other. As a result, the connection terminal 3 can be effectively fixed to the defogger 2 via the lead-free solder. Note that various fluxes can be used as the flux, and, for example, Gammalux (manufactured by Senju Metal Industry Co., Ltd.) can be used.
3. Various wire harnesses can be used as the wire harness 5. For example, a wire harness in which three or more electrically conductive cables 52 diverge from the connector 51 may be used. Furthermore, although the wire harness 5 in which a plurality of electrically conductive cables 52 diverge from a single connector 51 is used in the foregoing embodiment, a wire harness in which a single electrically conductive cable 52 extends from a single connector 51 may also be used. Moreover, in the case where a plurality of electrically conductive cables 52 are bound together, these electrically conductive cables 52 may respectively extend from the same number of connectors 51, or may extend from a plurality of connectors 51, the number of connectors 51 being different from the number of electrically conductive cables 52. For example, a configuration may be adopted in which a single electrically conductive cable 52 extends from a certain connector 51, a plurality of electrically conductive cables 52 extend from another connector 51, and these electrically conductive cables 52 are bound together with a single binding member 53.
4. Moreover, with regard to the wire harness 5, the wire harness 5 can be used in various forms such as a form in which the connection terminals 3 are attached to the respective electrically conductive cables 52 in advance, a form in which the lead-free solder 4 is applied to the connection terminals 3 in advance, and a form in which a flux is further applied to the lead-free solder 4 in advance.
5. In the foregoing embodiment, a tubular binding member is used as the binding member 53, but the electrically conductive cables 52 may also be bound together using a cord-like binding member. In addition, the binding member 53 may be attached to the electrically conductive cables 52 in advance during preparation of the wire harness 5 as described above, or may be attached to the electrically conductive cables 52 after the connection terminals 3 have been fixed to the defogger 2. There is no limitation on the timing of attachment.
6. In the foregoing embodiment, the lead-free solder 4 is melted by heating the connection terminal 3 and is thereby fixed to the defogger 2, but the method for melting the lead-free solder 4 is not limited to this. That is to say, various methods can be applied as long as lead-free solder can be melted by applying energy from the outside, for example, by applying hot air or by applying high-frequency waves.
7. The configuration of the defogger 2 is not limited, and with respect to the number of horizontal lines, the shape, and the like, the defogger 2 can be variously configured as long as the defogging effect can be achieved. With respect to the method for supplying power from the connection terminals 3 as well, various methods can be employed, and the configuration of the busbars and the configuration of the horizontal lines are not limited as long as any portion of the defogger 2 can be connected to a cathode and an anode via the connection terminals 3.
8. In the foregoing embodiment, an example was described in which the connection terminals 3 are fixed to the defogger 2, but apart from a defogger, any electrical component to which an electric current is supplied can be applied as the electrically conductive layer of the present invention. For example, an antenna may be applied.
9. In the foregoing embodiment, an example was described in which a glass plate module is mounted to a window frame of an automobile. In particular, if the glass plate module is applied to a convertible car with a cabin whose upper portion is openable, the effects of the present invention can be especially advantageously achieved. The reason for this is that in the convertible car, the connection terminals of the glass plate module are often located at positions that are likely to come into contact with a user. Note that the glass plate module according to the present invention can also be applied to a structure other than an automobile, such as a building.

### List of Reference Numerals

1: Glass plate
2: Defogger (electrically conductive layer)
3: Connection terminal
4: Lead-free solder
51: Connector
52: Electrically conductive cable
53: Binding member
10: Glass plate module

## Claims

1. A glass plate module comprising:
a glass plate;
an electrically conductive layer laminated on the glass plate;
a plurality of electrically conductive cables extending from a plurality of connectors or extending from a single connector;
a plurality of connection terminals arranged on the electrically conductive layer at an interval, connected to the respective electrically conductive cables, and made of an electrically conductive material;
lead-free solder for fixing the connection terminals to the electrically conductive layer; and
a binding member that binds the plurality of electrically conductive cables together between the connector(s) and the connection terminals.

2. The glass plate module according to claim 1,
wherein the connection terminals each have an installation portion that is installed on the electrically conductive layer and a connection portion to which the electrically conductive cable is connected, and
two of the connection terminals that are adjacent to each other are arranged on the electrically conductive layer such that the connection portions of the two connection terminals oppose each other, and the electrically conductive cables are bound together by the binding member between the two connection portions.

3. The glass plate module according to claim 1 or 2, wherein the lead-free solder has an Sn content of 90% or more.

4. The glass plate module according to any one of claims 1 to 3, wherein the lead-free solder has a shape that is flared from the connection terminal side toward the electrically conductive layer.

5. A convertible car comprising the glass plate module according to any one of claims 1 to 4.

6. A method for producing a glass plate module, the method comprising:
preparing a glass plate on which an electrically conductive layer is laminated;
preparing a plurality of electrically conductive cables extending from a plurality of connectors or extending from a single connector;
attaching connection terminals to the respective electrically conductive cables;
applying lead-free solder to the connection terminals;
applying a flux to the lead-free solder; and
melting the lead-free solder by applying energy from outside to the connection terminals, to thereby fix the connection terminals onto the electrically conductive layer via the lead-free solder,
wherein the plurality of electrically conductive cables are bound together between the connector (s) and the connection terminals.

7. A method for producing a glass plate module, the method comprising:
preparing a glass plate on which an electrically conductive layer is laminated;
preparing a plurality of electrically conductive cables extending from a plurality of connectors or extending from a single connector;
attaching connection terminals to the respective electrically conductive cables;
applying lead-free solder to the connection terminals;
applying a flux to a portion of the electrically conductive layer; and
melting the lead-free solder by applying energy from outside to the connection terminals, to thereby fix the connection terminals, via the lead-free solder, onto the electrically conductive layer to which the flux has been applied,
wherein the plurality of electrically conductive cables are bound together between the connector (s) and the connection terminals.

8. A method for producing a glass plate module, the method comprising:
preparing a glass plate on which an electrically conductive layer is laminated;
preparing a plurality of electrically conductive cables extending from a plurality of connectors or extending from a single connector;
preparing connection terminals to which lead-free solder is applied;
attaching the connection terminals to the respective electrically conductive cables;
applying a flux to the lead-free solder; and
melting the lead-free solder by applying energy from outside to the connection terminals, to thereby fix the connection terminals onto the electrically conductive layer via the lead-free solder,
wherein the plurality of electrically conductive cables are bound together between the connector (s) and the connection terminals.

9. A method for producing a glass plate module, the method comprising:
preparing a glass plate on which an electrically conductive layer is laminated;
preparing a plurality of electrically conductive cables extending from a plurality of connectors or extending from a single connector;
preparing connection terminals to which lead-free solder is applied;
attaching the connection terminals to the respective electrically conductive cables;
applying a flux to a portion of the electrically conductive layer; and
melting the lead-free solder by applying energy from outside to the connection terminals, to thereby fix the connection terminals, via the lead-free solder, onto the electrically conductive layer to which the flux has been applied,
wherein the plurality of electrically conductive cables are bound together between the connector (s) and the connection terminals.

10. A method for producing a glass plate module, the method comprising:
preparing a glass plate on which an electrically conductive layer is laminated;
preparing connection terminals to which a plurality of electrically conductive cables extending from a plurality of connectors or extending from a single connector are attached and lead-free solder is applied;
applying a flux to the lead-free solder; and
melting the lead-free solder by applying energy from outside to the connection terminals, to thereby fix the connection terminals onto the electrically conductive layer via the lead-free solder,
wherein the plurality of electrically conductive cables are bound together between the connector (s) and the connection terminals.

11. A method for producing a glass plate module, the method comprising:
preparing a glass plate on which an electrically conductive layer is laminated;
preparing connection terminals to which a plurality of electrically conductive cables extending from a plurality of connectors or extending from a single connector are attached and a flux and lead-free solder are applied;
attaching the connection terminals to the respective electrically conductive cables; and
melting the lead-free solder by applying energy from outside to the connection terminals, to thereby fix the connection terminals onto the electrically conductive layer via the lead-free solder,
wherein the plurality of electrically conductive cables are bound together between the connector (s) and the connection terminals.

12. A method for producing a glass plate module, the method comprising:
preparing a glass plate on which an electrically conductive layer is laminated;
preparing connection terminals to which a plurality of electrically conductive cables extending from a plurality of connectors or extending from a single connector are attached and a flux and lead-free solder are applied, the plurality of electrically conductive cables being bound together;
attaching the connection terminals to the respective electrically conductive cables; and
melting the lead-free solder by applying energy from outside to the connection terminals, to thereby fix the connection terminals onto the electrically conductive layer via the lead-free solder.

13. A method for producing a glass plate module, the method comprising:
preparing a glass plate on which an electrically conductive layer is laminated;
preparing connection terminals to which a plurality of electrically conductive cables extending from a plurality of connectors or extending from a single connector are attached and lead-free solder is applied;
applying a flux to a portion of the electrically conductive layer; and
melting the lead-free solder by applying energy from outside to the connection terminals, to thereby fix the connection terminals onto the electrically conductive layer via the lead-free solder,
wherein the plurality of electrically conductive cables are bound together between the connector (s) and the connection terminals.
